# EUROPEAN PATENT SPECIFICATION

(11) **EP 3 370 251 B1**
(45) Date of publication and mention of the grant of the patent: **04.11.2020**
(21) Application number: 17159268.6
(22) Date of filing: 03.03.2017
(51) Int. Cl.: H01L 21/265, H01L 21/268, H01L 27/146

(54) **METHOD FOR FORMING A SHALLOW JUNCTION IN A SEMICONDUCTOR SUBSTRATE**
VERFAHREN ZUR HERSTELLUNG EINES FLACHEN ÜBERGANGS IN EINEM HALBLEITERSUBSTRAT
PROCÉDÉ POUR FORMER UNE JONCTION PEU PROFONDE DANS UN SUBSTRAT SEMI-CONDUCTEUR

(43) Date of publication of application: 05.09.2018
(73) Proprietor: Laser Systems & Solutions of Europe, 92230 Gennevilliers (FR)
(72) Inventor: Mazzamuto, Fulvio, 75018 Paris (FR)
(74) Representative: Jacobacci Coralis Harle

(56) References cited:
- EP-A1- 2 200 084
- JP-A- S5 671 937
- US-A1- 2010 059 843

## Description

### BACKGROUND AND SUMMARY OF THE INVENTION

The invention relates generally to a method of making a shallow junction in semiconductor substrate and in particular an uncontaminated shallow junction.

A surface passivation shallow junction is necessary in back illuminated Cmos image sensor to limit losses of short wavelength signal.

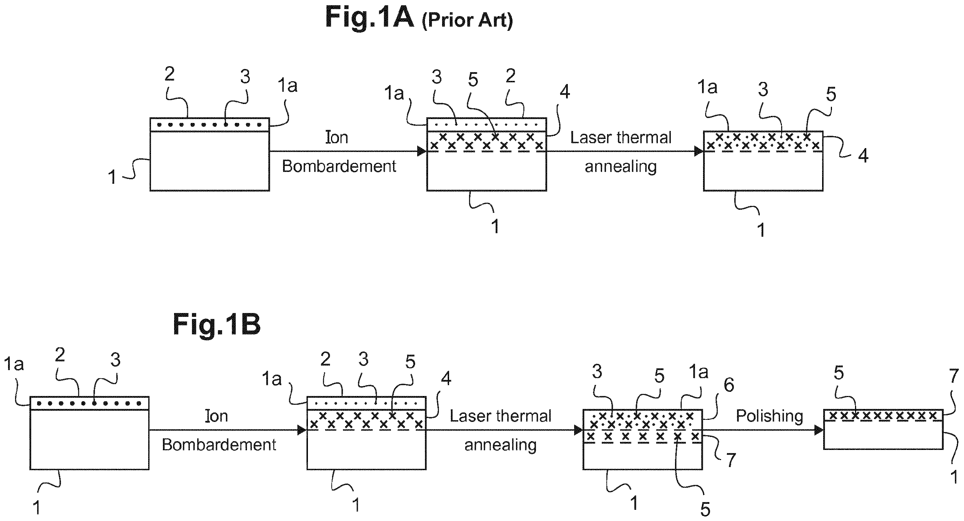

Shallow junction in a semiconductor substrate, such as a silicon wafer, is typically realized as shown in Figure 1A by first bombarding a surface of the semiconductor substrate 1 with ions at low energy to limit the dopant 5 penetration and create a shallow ion implanted region 4 and thereafter submitting the semiconductor substrate to a melting laser annealing treatment to fully activate and diffuse the dopants 5.

An atomic oxygen-based interface layer 2 is always present at the interface air/substrate before laser annealing treatment.

The oxidation problem can be solved by removing the oxygen-based interface layer and depositing a capping layer on the substrate surface. However, independently from the material and the deposition technique, an atomic interface layer 2 with low melting temperature containing contaminants other than oxygen is always present. (See Y. Liao and al., Applied Physics A: Materials Science, vol. 82, 679-682, (2006).

Melting laser annealing treatment induces extremely high surface temperatures on the substrate (more than 1400°C to melt silicon). At such very high temperature, the interface layer 2 is always molten and diffuses inside the molten substrate.

Diffusion depth depends on the atomic elements 3 (contaminants) in the interface layer 2, then diffusion coefficients in the substrate liquid phase, and the substrate melting time. Contaminants, particularly oxygen, can drastically decrease the quality of the substrate lattice. (See Vanhellemont J.; Simoen E.; Kaniava A.; Libezny M.; Claeys C.; "Impact of oxygen related extended defects on silicon diode characteristics", Journal of Applied Physics, vol. 77, n° 11, pp. 5669, 5676, Jun. 1995).

This problem is crucial regarding back illuminated Cmos image sensors (BSI-CIS) which are strongly sensible to the lattice quality.

Although the present description will mainly refer to oxygen as the contaminant and silicon as semiconductor substrate material, it concerns all contaminants that can be present in the interface layer 2 and diffuse in the semiconductor substrate during the melting laser annealing treatment, as well as to other semiconductor substrate material, such as for example Ge and SiGe. Other contaminants are, for instance, nitrogen and carbon.

The problem of oxygen incorporation within the substrate during melting laser annealing treatment is well known and has been extensively studied for amorphous to poly-Si recrystallization. (See Koichito Hoh, Hiroshi Koyama, Keiichiro Udal and Yoshio Miura "Incorporation of Oxygen into Silicon during Pulsed-Laser Irradiation" Jpn J. Appl. Phys. 19 (1980), pp. L375-L378)

Some solutions have already been suggested.

For examples, US patent N° 6,071,796 proposes to control oxygen content by directing inert gas onto the surface of the silicon film during irradiation of the target region. However, this solution is not very efficient and somewhat difficult to implement.

Other solutions are directed to totally different processes which do not use ion implantation and laser annealing treatment. See, for example, US Patent Application n° 2009/0230496A1.

JP S56 71937 A (CHO LSI GIJUTSU KENKYU KUMIAI) 15 June 1981 (1981-06-15) discloses a method of forming a junction using ion implantation followed by pulsed laser irradiation.

Thus, the aim of the present invention is to provide a method for forming a shallow junction in a semiconductor substrate, using ion implantation and melting laser annealing treatment which is almost free of contaminants.

According to the invention, there is provided a method for forming a shallow junction in a semiconductor substrate having an interface layer on a first surface of said substrate, comprising the steps of:
a) bombarding said first face with ions so as to implant ions into said semiconductor substrate and to form an ion implanted region having a predetermined implantation depth; and
b) irradiating said first face with a pulsed laser beam to melt said semiconductor substrate to at least the predetermined implantation depth;
characterized in that:
- said pulsed laser beam has an energy density and a pulse duration selected to form within said ion implanted region a first layer extending from the first face and including implanted ions and contaminants having diffused from said interface layer, and a second layer extending from the first layer deeper into the semiconductor substrate and including implanted ions and contaminants in an atomic concentration of contaminants/ lower than 10¹⁸ at/cm³, preferably lower than 10¹⁷ at/cm³ and in that:
- it further comprises a step c) of removing at least said first layer from the semiconductor substrate, said junction being formed at the interface between said second layer and a subjacent non-molten part of the semiconductor substrate.

In further specific embodiments, the method of the invention comprises alone or in combination the following features:
- step c) comprises removing a part of the second layer;
- step c) is a final step of chemical-mechanical polishing;
- step c) is a wet etching step.

In a preferred embodiment of the invention, the method for forming the shallow junction comprises, before step a):
- a step of raw grinding of the first face of the semiconductor substrate, and then
- an initial step of chemical-mechanical polishing of the first face.

### BRIEF DESCRIPTION OF THE DRAWINGS

Figure 1A is a schematic drawing of prior art method for forming a shallow junction using ion implantation and melting laser annealing treatment;
Figure 1B is a schematic drawing of the method of the invention; and
Figure 2 are graphs of the atomic concentration of contaminants (oxygen) and implanted ions (boron) in function of the depth in the substrate as determined by Secondary Ion Mass Spectroscopy (SIMS).

### DETAILED DESCRIPTION AND PREFERRED EMBODIMENT

Figure 1B is a schematic illustration of the method of the invention.

The semiconductor substrate 1, for example a silicon wafer, having a first surface 1a covered with an interface layer 2 containing contaminants 3, usually an atomic oxygen-based interface layer is submitted to an ion bombardment (for example boron ions) through its first face to form within the semiconductor substrate 1 under the first face 1a, an ion implanted region 4 containing dopants 5.

The ion implantation step can be any classical ion implantation method generally used in the technical field. Reference can be made to "Ziegler, James F., ed. Ion Implantation Science and Technology 2e. Elsevier, 2012."

However, according to the present invention, the ion implantation parameters are selected to preferably obtain a predetermined ion implantation depth which is greater than the expected diffusion depth of the contaminants within the semiconductor substrate during the subsequent melting laser annealing treatment.

Thus, for instance, by using an UV excimer laser (Energy density: 3 J/cm²;pulse duration 160 ns) to melt a silicon wafer to a 350 nm depth from the wafer surface, oxygen diffusion is observed up to 250 nm. Therefore, implanting ions deeper than 250 nm and up to 350 nm will leave an ion implanted and activated oxygen free layer available between 250 nm and 350 nm.

Typically, the ion implantation energy is in the interval [1; 100keV].

Thereafter, the semiconductor substrate 1 is subjected through its first face 1a to a melting laser thermal annealing treatment, using a pulsed laser beam, to diffuse and activate the ion dopants.

According to the invention, the pulsed laser beam energy density and the pulse duration are selected so that the melting laser annealing treatment forms within the ion implanted region 4 a first layer 6 extending from the first face 1 within the ion implanted region 4 which includes implanted ions 5 and contaminants 3 having diffused from interface layer 2 and a second layer 7 extending from the first layer 6 deeper within the semiconductor substrate and including implanted ions 5 and contaminants 3 wherein the atomic ratio "contaminants/implanted ions" is lower than a predetermined threshold.

Typically, the energy density of the pulsed laser beam is in the interval [0.1 to 10 J/cm²] preferably [1 to 10 J/cm²] and even better [1 to 5 J/cm²] and the pulse duration is in the interval [1 to 200 ns], preferably [120-180ns].

Of course, the atomic concentration of contaminants in the second layer 7 or at least in deeper portion of second layer 7 shall be low.

Typically, the atomic concentration of contaminants in second layer 7 is lower than 10¹⁸at /cm³ preferably lower than 0.5 10¹⁸at /cm³, even better lower than 10¹⁷ at / cm³

Atomic concentrations are determined by Secondary Ion Mass Spectroscopy (SIMS).

Following the melting layer annealing treatment, at least the first layer 6 is removed so that a shallow junction is formed at the interface between the second layer 7 and the subjacent non-molten part of the semiconductor substrate 1.

In some embodiments, a portion of the second layer 7 may also be removed in order to achieve the requested contaminants concentration within the ion implanted area.

Removal of the first layer 6 and possibly of a portion of the second layer 7 can be effected using any known removal method such as known mechanical and chemical methods or a combination thereof. Removal can also be effected by thermal oxidation and then selective etching of the oxide. After removal, the second layer has usually a thickness in the interval [10 nm; 1µm]; preferably equal to or lower than 100nm.

Typically, the first layer 6 removal is a final step of chemical/mechanical polishing or a wet etching step.

Several possible technics can be used:
1) Purely wet chemical etching:
   This is a well known etching technic using KOH or TMAH. KOH is potassium hydroxide. TMAH stands for Tetramethyl ammonium hydroxide. Both compounds are commonly used for etching silicon. [KNOTTER, D. M. (2010) THE CHEMISTRY OF WET ETCHING, IN HANDBOOK OF CLEANING IN SEMICONDUCTOR MANUFACTURING: FUNDAMENTAL AND APPLICATIONS (EDS K. A. REINHARDT AND R. F. REIDY), JOHN WILEY & SONS, INC., HOBOKEN, NJ, USA. DOI: 10.1002/9781118071748.CH3]
2) Dry etching [NOJIRI, KAZUO. DRY ETCHING TECHNOLOGY FOR SEMICONDUCTORS. SPRINGER, 2014.]:
   a. Reactive Ion Etching (RIE):
      This is a plasma etching technology. During RIE etching processes, volatile compounds are formed in interaction of sample surfaces and high-energy ions/radicals generated by low-pressure plasma. The volatile compounds are removed from the sample surfaces, and isotropic or anisotropic profile is achieved. SF6 is often use for etching Si;
   B. DIRECT PLASMA: High-energy ions are sputtered on the surface to remove the layer.
3) Chemical mechanical polishing [Oliver, Michael R., ed. Chemical-mechanical planarization of semiconductor materials. Vol. 69. Springer Science & Business Media, 2013.]:
   - A physical removal of the layer by a soft grinding assisted by chemistry (to control the removed thickness and avoid important defects).
4) Thermal oxidation [Declerck, G. J., Silicon Oxidation - Microelectronic Materials and Processes (1989) Springer Pages 79-132, 978-94-009-0917-5]:
   - Layer can be thermally oxidized. The oxide layer formed can be maintained (inactive) or easily chemically etched (i.e. with HF solutions).

All these processes are well known in the art

Chemical/mechanical polishing initial step can be implemented as disclosed above.

### Example:

Silicon wafers having the characteristics given below are treated according to the invention as indicated hereinunder.

### 1) Silicon wafer characteristics:

Silicon epitaxially grown on standard Czochralski (CZ) wafers.

The silicon epitaxially grown wafer is well known to achieve a better level of purity (oxygen contamination << 10¹⁷ at/cm³) than a standard CZ wafer (oxygen contamination < 10¹⁸ at/cm³).

### 2) Implantation

| Apparatus | Implanted Ions | Implantation Parameters |
|---|---|---|
| Medium current ion | B | Energy 30 keV |
| implantation system | | Implanted dose 10¹⁵ at/cm² Tilt angle 7° |

### 3) Pulsed laser beam treatment

| | Irradiation parameters | |
|---|---|---|
| Apparatus | Energy density | Pulse duration |
| UV excimer laser | 3/3.5/4 J/cm² | 160 ns |
| λ = 308 nm | | |

After the pulse laser beam treatment, the atomic concentrations of both oxygen and boron in the wafer has been determined by SIMS.

Also, oxygen and boron atomic concentrations of a silicon wafer subjected to same ion implantation but no pulsed laser beam treatment have been determined.

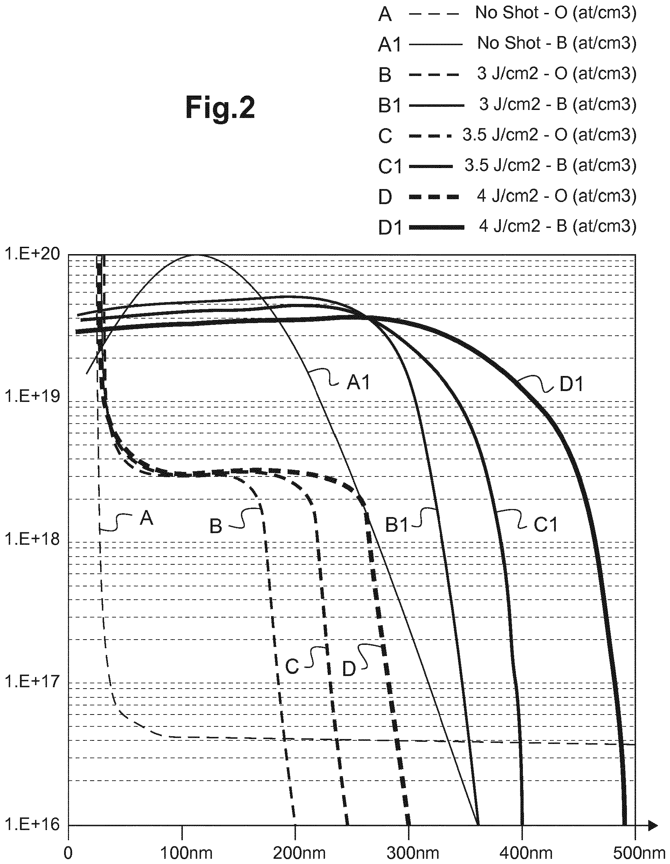

Results are shown in Figure 2.

Figure 2 clearly shows that the method of the invention results in a first layer up to 250 nm depth having significant atomic concentration of oxygen and a second layer from 250 nm to 350 nm depth with much lower atomic concentration of oxygen while the atomic boron concentration remains almost stable.

4) The obtained silicon wafers are then subjected to a chemical/mechanical polishing to obtain the final product.

Removing 250 to 350 nm by chemical/mechanical polishing will form an uncontaminated junction of 10 to 150 nm. For example, using laser annealing at 3.5 J/cm², removing 300 nm by chemical/mechanical polishing will form an uncontaminated junction of 100nm.

## Claims

1. Method for forming a shallow junction in a semiconductor substrate (1)having an interface layer (2) containing contaminants (3) on a first face (1a) of said substrate, comprising the steps of:
a) bombarding said first face (1a) with ions so as to implant ions into said semiconductor substrate (1) and to form an ion implanted region (4) having a predetermined implantation depth; and
b) irradiating said first face with a pulsed laser beam so as to melt said semiconductor substrate (1) to at least the predetermined implantation depth;
wherein said pulsed laser beam has an energy density and a pulse duration selected to form within said ion implanted region (4) a first layer (6) extending from the first face (1a) and including the implanted ions and the contaminants having diffused from said interface layer; and a second layer (7) extending from the first layer (6) deeper into the semiconductor substrate (1) and including implanted ions and an atomic concentration of contaminants lower than 10¹⁸ at/cm³, preferably lower than 10¹⁷ at/cm³ and in that it further comprises a step c) of removing at least said first layer (6) from the semiconductor substrate (1), said junction being formed at the interface between said second layer (7) and a subjacent non-molten part of the semiconductor substrate (1).

2. Method according to claim 1, wherein step c) comprises removing a part of the second layer (7).

3. Method according to claim 1 or 2, wherein step c) is a final step of chemical-mechanical polishing.

4. Method according to claim 1 or 2, wherein step c) is a step of wet etching.

5. Method according to claim 3 or 4, comprising, before step a):
- a step of raw grinding of the first face of the semiconductor substrate, and then
- an initial step of chemical-mechanical polishing of the first face.

6. Method according to anyone of claims 1 to 5, wherein the interface layer is an oxide layer.

7. Method according to anyone of claims 1 to 6, wherein the thickness of the second layer left after step c) has a thickness in the interval [10 nm; 1µm]; preferably equal to or lower than 100nm.

8. Method according to anyone of claims 1 to 7, wherein, in step a), ions have an implantation energy ranging from 1 to 100 keV.

9. Method according to anyone of claims 1 to 8, wherein, in step b), the energy density of said pulsed laser beam ranges from 0.1 and 10 J/cm², preferably 1 to 5 J/cm².

10. Method according to anyone of claims 1 to 9, wherein the laser beam pulse has a duration ranging from 100 ns to 200ns, preferably form 120 ns to 180ns.

## Patentansprüche

1. Verfahren zur Herstellung eines flachen Übergangs in einem Halbleitersubstrat (1) mit einer Schnittstellenschicht (2), enthaltend Verunreinigungen (3) auf einer ersten Fläche (1a) des Substrats, umfassend die folgenden Schritte:
a) Beschießen der ersten Fläche (1a) mit Ionen, um Ionen in das Halbleitersubstrat (1) zu implantieren und ein ionenimplantiertes Gebiet (4) mit einer vorbestimmten Implantationstiefe herzustellen; und
b) Bestrahlen der ersten Fläche mit einem gepulsten Laserstrahl, um das Halbleitersubstrat (1) mindestens bis zur vorbestimmten Implantationstiefe zu schmelzen;
wobei der gepulste Laserstrahl eine Energiedichte und eine Pulsdauer aufweist, die so gewählt sind, dass innerhalb des ionenimplantierten Gebiets (4) eine erste Schicht (6) hergestellt wird, die sich von der ersten Fläche (1a) erstreckt und die implantierten Ionen und die Verunreinigungen, von der Schnittstellenschicht diffundiert, enthält; und eine zweite Schicht (7), die sich von der ersten Schicht (6) tiefer in das Halbleitersubstrat (1) erstreckt und implantierte Ionen und eine Atomkonzentration von Verunreinigungen unter 10¹⁸ at/cm³, bevorzugt unter 10¹⁷ at/cm³ enthält, und dass es weiterhin einen Schritt c) des Entfernens mindestens der ersten Schicht (6) von dem Halbleitersubstrat (1) umfasst, wobei der Übergang an der Grenzfläche zwischen der zweiten Schicht (7) und einem darunterliegenden ungeschmolzenen Teil des Halbleitersubstrats (1) hergestellt wird.

2. Verfahren nach Anspruch 1, wobei Schritt c) das Entfernen eines Teils der zweiten Schicht (7) umfasst.

3. Verfahren nach Anspruch 1 oder 2, wobei Schritt c) ein finaler Schritt des chemisch-mechanischen Polierens ist.

4. Verfahren nach Anspruch 1 oder 2, wobei Schritt c) ein Schritt des Nassätzens ist.

5. Verfahren nach Anspruch 3 oder 4, umfassend, vor Schritt a):
- einen Schritt des Grobschleifens der ersten Fläche des Halbleitersubstrats, und dann
- einen anfänglichen Schritt des chemisch-mechanischen Polierens der ersten Fläche.

6. Verfahren nach einem der Ansprüche 1 bis 5, wobei die Schnittstellenschicht eine Oxidschicht ist.

7. Verfahren nach einem der Ansprüche 1 bis 6, wobei die Dicke der nach Schritt c) verbleibenden zweiten Schicht eine Dicke im Intervall [10 nm; 1 µm]; bevorzugt kleiner oder gleich 100 nm, beträgt.

8. Verfahren nach einem der Ansprüche 1 bis 7, wobei in Schritt a) Ionen eine Implantationsenergie im Bereich von 1 bis 100 keV aufweisen.

9. Verfahren nach einem der Ansprüche 1 bis 8, wobei in Schritt b) die Energiedichte des gepulsten Laserstrahls im Bereich von 0,1 und 10 J/cm², bevorzugt 1 bis 5 J/cm², liegt.

10. Verfahren nach einem der Ansprüche 1 bis 9, wobei der Laserstrahlimpuls eine Dauer im Bereich von 100 ns bis 200 ns, bevorzugt von 120 ns bis 180 ns, aufweist.

## Revendications

1. Procédé pour la formation d'une jonction peu profonde dans un substrat semi-conducteur (1) comportant une couche d'interface (2) contenant des contaminants (3) sur une première face (la) dudit substrat, comprenant les étapes de :
a) bombardement de ladite première face (1a) avec des ions de façon à implanter des ions dans ledit substrat semi-conducteur (1) et à former une région implantée d'ions (4) ayant une profondeur d'implantation prédéfinie ; et
b) exposition de ladite première face à un faisceau laser pulsé de façon à fondre ledit substrat semi-conducteur (1) jusqu'à au moins la profondeur d'implantation prédéfinie ;
**caractérisé en ce que** ledit faisceau laser pulsé a une densité énergétique et une durée d'impulsion sélectionnées afin de former à l'intérieur de ladite région implantée d'ions (4) une première couche (6) s'étendant depuis la première face (la) et comprenant les ions implantés et les contaminants s'étant diffusés depuis ladite couche d'interface ; et une seconde couche (7) s'étendant depuis la première couche (6) plus profondément dans le substrat semi-conducteur (1) et comprenant des ions implantés et une concentration atomique de contaminants inférieure à 10¹⁸ at/cm³, de préférence inférieure à 10¹⁷ at/cm³ et **en ce qu'**il comprend en outre une étape c) d'élimination d'au moins ladite première couche (6) du substrat semi-conducteur (1), ladite jonction étant formée au niveau de l'interface entre ladite seconde couche (7) et une partie non fondue sous-jacente du substrat semi-conducteur (1).

2. Procédé selon la revendication 1, dans lequel l'étape c) comprend l'élimination d'une partie de la seconde couche (7).

3. Procédé selon la revendication 1 ou 2, dans lequel l'étape c) est une étape finale de polissage chimico-mécanique.

4. Procédé selon la revendication 1 ou 2, dans lequel l'étape c) est une étape de gravure humide.

5. Procédé selon la revendication 3 ou 4, comprenant, avant l'étape a) :
- une étape de meulage préliminaire de la première face du substrat semi-conducteur, puis
- une étape initiale de polissage chimico-mécanique de la première face.

6. Procédé selon l'une des revendications 1 à 5, dans lequel la couche d'interface est une couche d'oxyde.

7. Procédé selon l'une des revendications 1 à 6, dans lequel l'épaisseur de la seconde couche restant après l'étape c) est dans l'intervalle [10 nm ; 1 µm] ; de préférence égale ou inférieure à 100 nm.

8. Procédé selon l'une quelconque des revendications 1 à 7, dans lequel, dans l'étape a), les ions ont une énergie d'implantation dans la plage de 1 à 100 keV.

9. Procédé selon l'une quelconque des revendications 1 à 8, dans lequel, dans l'étape b), la densité énergétique dudit faisceau laser pulsé est dans la plage de 0,1 à 10 J/cm², de préférence de 1 à 5 J/cm².

10. Procédé selon l'une des revendications 1 à 9, dans lequel l'impulsion du faisceau laser a une durée dans la plage de 100 ns à 200 ns, de préférence de 120 ns à 180 ns.
